# EUROPÄISCHE PATENTSCHRIFT

(11) **EP 2 143 308 B1**
(45) Veröffentlichungstag und Bekanntmachung des Hinweises auf die Patenterteilung: **17.01.2018**
(21) Anmeldenummer: 07727771.3
(22) Anmeldetag: 04.04.2007
(51) Int. Cl.: H05K 1/00, H01H 85/046

(54) **DOPPELSEITIGE PLATINE MIT LEITERBAHNSICHERUNG**
DOUBLE-SIDED PLATE COMPRISING A STRIP CONDUCTOR SAFETY FUSE
PLATINE DOUBLE FACE PRÉSENTANT UN FUSIBLE POUR PISTES CONDUCTRICES

(43) Veröffentlichungstag der Anmeldung: 13.01.2010
(73) Patentinhaber: OSRAM GmbH, 80807 München (DE)
(72) Erfinder: CASPER, Günther, 83727 Schliersee (DE); WERNI, Horst, 80937 München (DE)
(86) Internationale Anmeldenummer: PCT/EP2007/053300
(87) Internationale Veröffentlichungsnummer: WO 2008/122309

(56) Entgegenhaltungen:
- EP-A- 1 308 978
- EP-A- 1 638 125
- DE-A1- 10 125 476
- DE-U1- 20 023 606

## Beschreibung

### Technisches Gebiet

Die Erfindung betrifft eine doppelseitige Platine mit einer Leiterbahnsicherung gemäß dem Oberbegriff des Patentanspruchs 1.

### Stand der Technik

Die Leiterbahnsicherung einer Platine hat die Aufgabe, bei einem anormalen Betriebszustand, insbesondere bei einem Kurzschluss, die Verbindung zur Spannungsversorgung schnell und zuverlässig zu unterbrechen. Damit soll verhindert werden, dass sich der Kurzschluss auf der Platine ausbreitet und weiteren Schaden anrichtet. Außerdem soll durch das frühzeitige Ansprechen der Leiterbahnsicherung vermieden werden, dass ein Netzschutzschalter ausgelöst wird.

Zu diesem Zweck wird häufig ein bestimmter Leiterbahnabschnitt auf der Platine als Schmelzsicherung ausgeführt. Dieser Leiterbahnabschnitt hat einen im Vergleich zu den anderen Leiterbahnen auf der Platine verengten Querschnitt, der bei Auftreten eines Kurzschlusses kontrolliert schmelzen und so den Stromkreis unterbrechen soll.

Ein Problem dabei ist, dass das beim Schmelzen und Verdampfen der Schmelzsicherung auftretende Plasma ein neues, niederohmig unter Netzspannung stehendes Kontaktpaar findet und dadurch unkontrolliert weiterbrennt. Auf diese Weise wird ein indirekter Kurzschluss ausgelöst, der meistens zwischen Lötstellen und/oder wesentlich breiteren Leiterbahnen brennt und aufgrund der größeren verfügbaren Metallmenge wesentlich mehr leitfähiges Plasma erzeugt als der eigentliche Kurzschluss und somit weiteren Schaden auf der Platine verursacht. Der Prozess schaukelt sich so lange auf, bis schließlich der Netzschutzschalter ausgelöst wird. Je niederohmiger das anschließende Netzfilter ist, d.h. je höher die Nennleistung des Geräts ist, desto häufiger tritt der soeben beschriebene Fall ein.

Ein Lösungsversuch für dieses Problem findet sich in der EP 0 774 887 A2. Diese zeigt eine Leiterbahnsicherung, bei der zwei gegensinnig von Strom durchflossene Leiterbahnabschnitte möglichst parallel in einem geringen Abstand zueinander angeordnet sind, so dass die Leiterbahn insgesamt eine U-Form aufweist. Durch den geringen Abstand stehen die Magnetfelder im Bereich der Leitungsabschnitte in Wechselwirkung miteinander. Einer der Leiterbahnabschnitte hat einen verengten Querschnitt und schmilzt im Falle eines Kurzschlusses. Das dabei entstehende Plasma wird durch die Wechselwirkung der Magnetfelder vom benachbarten Leiterabschnitt ferngehalten und es kann ein Weiterbrennen des Plasmas vermieden werden.

Hiermit kann das Eingangs geschilderte Problem jedoch nicht zuverlässig und für jede Anwendung gelöst werden. Vor allem bei dicht bestückten Platinen besteht die Gefahr, dass das Plasma zu anderen benachbarten Leiterbahnen überspringt, in denen noch kein Kurzschlussstrom fließt und die demzufolge auch kein (wie auch immer gepoltes) für die Abstoßung des Plasmas ausreichend starkes Magnetfeld haben. Außerdem wird es aus Platzgründen nicht immer möglich sein, diese U-förmige Leiterbahnsicherung auf jeder Platine unterzubringen.

In der DE 37 23 832 Al ist eine Leiterbahnsicherung offenbart, bei der ebenfalls eine Schmelzsicherung verwendet wird, die einen in diesem Fall durch eine Aussparung verringerten Leiterbahnquerschnitt hat. Diese Stelle mit dem verringerten Querschnitt wird mit einem funkenlöschenden Medium abgedeckt. Außerdem soll die Aussparung in der Schmelzsicherung, die z.B. eine Bohrung sein und bis durch die Platine hindurchreichen kann, ein Abströmen der beim Schmelzen entstehenden Gase ermöglichen. Eine Platine gemäß dem Oberbegriff des Anspruchs 1 zeigt das Dokument EP 1 638 125.

Problematisch an dieser Lösung ist die komplizierte Anbringung der Abdeckschicht und Herstellung der Aussparung in der Leiterbahn. Des Weiteren kann unter der Abdeckschicht ein sich ungünstig auf die Unterbrechung des Kurzschluss-Stroms auswirkender Hitzestau entstehen.

### Aufgabe

Der Erfindung liegt die Aufgabe zugrunde, die Betriebssicherheit der Platine mit einfachen Mitteln zu verbessern.

Diese Aufgabe wird erfindungsgemäß durch die Merkmale des Anspruchs 1 gelöst. Besonders vorteilhafte Ausführungen der Erfindung sind in den abhängigen Ansprüchen beschrieben.

### Darstellung der Erfindung

Bei der erfindungsgemäßen Platine ist der als Schmelzsicherung ausgeführte Leiterbahnabschnitt auf der anderen Platinenseite als die restliche Leiterbahn. Dies hat den großen Vorteil, dass im Kurzschlussfall nur das Material dieses Abschnitts verdampfen kann, da ein Materialabtrag durch die Durchkontaktierungen aus verschiedenen Gründen sehr unwahrscheinlich ist. Zum einen ist die zu verdampfende Metallmenge in einer Durchkontaktierung vergleichsweise Groß, zum anderen ist diese Masse sehr kompakt in der Durchkontaktierung vorhanden und schon deshalb ist eine große Sicherheit vor unkontrolliertem Weiterbrennen des Plasmas im Kurzschlussfall vorhanden.

Die erfindungsgemäße Leiterbahnsicherung hat den weiteren Vorteil einer möglichen platzsparenden Auslegung dieser Sicherung. Dadurch, dass beide Seiten der Leiterplatte für die Sicherung verwendet werden, ist der Gesamtflächenbedarf auf der Leiterplatte reduziert.

Sollten für den Seitenwechsel sehr feine Durchkontaktierungen mit wenig Metallmasse verwendet werden, so kann es von Vorteil sein, wenn die Durchkontaktierungen mit SMD-Klebepunkten belegt werden, um ein Abbrennen des Plasmas durch die Kontaktierung sicher verhindern zu können. Da die Unterseite, aber auch die Oberseite der Platine bei modernen elektronischen Betriebsgeräten üblicherweise zum Teil mit SMD-Bauteilen bestückt ist, werden vor dem Bestücken dieser Bauteile eine Vielzahl von Klebepunkten aufgebracht, die die darauf bestückten Bauteile bis zum Lötvorgang in Position halten sollen. Daher gehen die Mehrkosten von zwei zusätzlichen Klebepunkten auf den Durchkontaktierungen gegen Null.

Um im Falle eines Kurzschlusses ein Übergreifen des Plasmas auf benachbarte Leiterbahnen zu unterbinden, ist es von Vorteil, wenn sich zwischen dem Schmelzsicherungsteil der Leiterbahn und den benachbarten Leiterbahnen eine Trennwand befindet. Die Trennwand kann an der Platine angebracht sein, sie kann aber auch Teil des Gehäuses sein. Dies hat den Vorteil einer einfachen Montage und geringen Kosten. Auf der Seite, die der Schmelzsicherung zugewandt ist, kann die Trennwand vorzugsweise mit einer als Diffusor wirkenden zusätzlichen isolierenden Ablenkfläche versehen sein, um das bei einem Schmelzen der Schmelzsicherung entstehende Plasma, das sich in Richtung der benachbarten Leiterbahn bewegt, von dieser weg abzulenken und den Plasmastrahl aufzuweiten. Dadurch kann ein Ausbreiten und Überspringen des Plasmas auf benachbarte Leiterbahnen und somit ein indirekter Kurzschluss auf wirkungsvolle und einfache Weise verhindert werden.

Zum besseren Reflektieren und Ablenken des Plasmas kann die Ablenkfläche eben ausgebildet und in Bezug auf die Trennwandebene schräg angestellt, wobei der Winkel so gewählt ist, dass das Plasma weg von der benachbarten Leiterbahn gelenkt wird und zudem eine leichte Herstellbarkeit gewährleistet ist.

Für die Anstellung der Schrägfläche kann in Bezug zu der Trennwandebene und der Platinenoberfläche ein Winkel von 45° gewählt werden.

Es ist auch möglich, eine Trennwand durch geeignete Bauteile, wie z.B. gebecherte Kondensatoren, auszubilden. Dies stellt für viele Fälle eine gangbare weil ausreichend sichere, und deutlich kosteneffektivere Lösung dar.

### Kurze Beschreibung der Zeichnung(en)

- Fig. 1: Draufsicht auf den Zuführungsteil der erfindungsgemäßen Leiterbahnsicherung auf der Leiterplatte.
- Fig. 2: Schnitt durch eine erfindungsgemäße Leiterbahnsicherungsanordnung.
- Fig. 3: Draufsicht auf den Schmelzsicherungsteil der erfindungsgemäßen Leiterbahnsicherung auf der Leiterplatte.
- Fig. 4a: Schnittansicht eines Details der Leiterbahnsicherung mit einem SMD-Klebepunkt.
- Fig. 4b: Draufsicht eines Details der Leiterbahnsicherung mit einem SMD-Klebepunkt.
- Fig. 5: Darstellung der Leiterbahnsicherung im Zusammenspiel mit einer Trennwand, die eine schräge Ablenkfläche aufweist.
- Fig. 6: Darstellung der Leiterbahnsicherung im Zusammenspiel mit einer Trennwand, die zwei schräge Ablenkflächen aufweist. Bevorzugte Ausführung der Erfindung

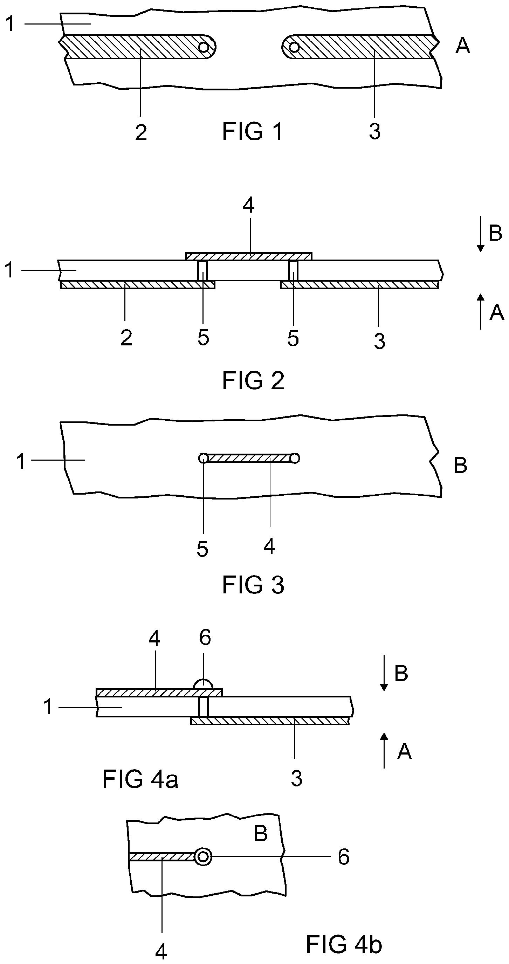

Wie in den Fig. 1-3 ersichtlich, ist die Leiterbahnsicherung in zwei Abschnitte aufgeteilt: den auf einer Seite der Platine verlaufenden Zuführungsteil 2, 3, und den auf der anderen Seite der Platine verlaufenden Schmelzsicherungsteil 4. Die beiden Teile werden mit 2 Durchkontaktierungen 5 verbunden. Die Durchkontaktierungen 5 können, wie in der Fig. 2 Dargestellt reine Vias sein, sie können aber auch durch ein bedrahtetes Bauteil, z.B. einen Widerstand mit einem hohen Wert, gebildet werden.

Wie die Fig. 4a und 4b zeigen, wird die Durchkontaktierung 5 bevorzugt als reines Via ausgeführt, und auf der Seite der Schmelzsicherung 4 mit einem Klebepunkt 6 aus SMD-Klebstoff überdeckt. Dieser kann im Zuge der SMD-Bestückung aufgebracht werden, so dass kein zusätzlicher Arbeitsgang notwendig ist. Der Klebepunkt 6 trägt zusätzlich dazu bei, dass im Falle eines Kurzschlusses das Plasma 21 nicht durch die Durchkontaktierung brennen kann.

Für den Fall, dass zwei Leiterbahnsicherungen jeweils auf unterschiedlichen Platinenseiten vorgesehen sind, können die SMD-Klebepunkte auch auf die Seite der Zuführungsteile der Durchkontaktierungen aufgebracht werden.

Somit wird nur das zwischen den Durchkontaktierungen 5 liegende schmale Leiterbahnstück 4 verdampft was eine saubere und sichere Trennung vom Netz gewährleistet.

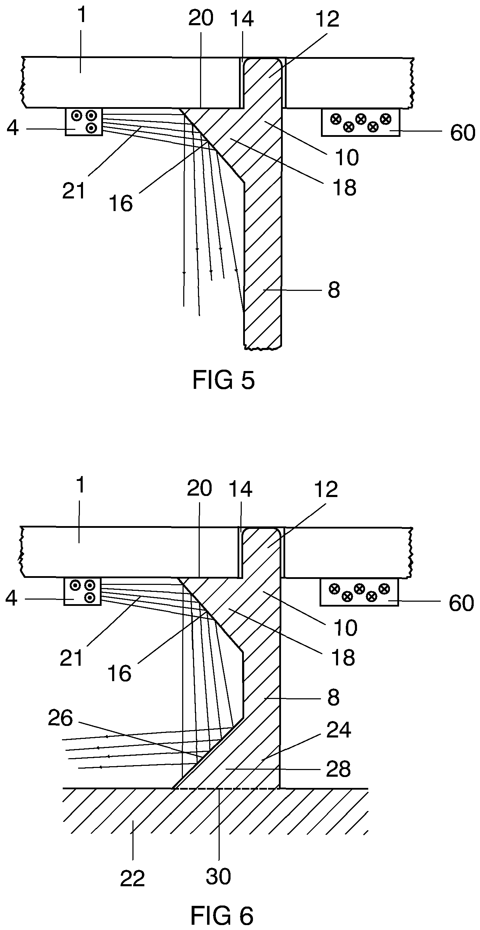

Bei Geräten größerer Leistung kann der KurzschlussStrom so groß sein, dass eine gewisse Gefahr besteht, dass im Falle eines Kurzschlusses das leitende Plasma 21 auf andere Leiterbahnen übergreift (Fig. 5 & 6). Hier ist es sinnvoll, zwischen der Schmelzsicherung 4 und benachbarten Leiterbahnen 60 eine Trennwand 8 vorzusehen, die das Plasma 21 davon abhält, in die Bereiche der benachbarten Leiterbahnstücke 60 vorzudringen. Die Trennwand 8 hat vorzugsweise eine der Schmelzsicherung 4 zugewandte Ablenkfläche 16, die in einem schrägen Winkel zur Leiterplattenoberfläche angeordnet ist. Im Kurzschlussfall wird das von der Schmelzsicherung 4 weg auf die Ablenkfläche 16 und die benachbarten Leiterbahnstücke 60 zuströmende Plasma 21 von der Leiterbahnoberfläche weggelenkt und gestreut, so dass dessen Leitfähigkeit sinkt. Diese Umlenkung bewirkt, dass kein Plasma 21 mehr in die Nähe benachbarter Leiterbahnstücke gelangen kann.

Die Ablenkfläche 16 kann z.B. in einem Winkel von 45° zur Leiterplattenoberfläche angeordnet sein. Die Trennwand 8 und die Ablenkfläche 16 können ein Bauteil bilden, dass an der Leiterplatte befestigt wird, z.B. durch Einclipsen in eine Ausnehmung 14 der Leiterplatte. Wie in Fig. 6 dargestellt kann die Trennwand 8 auch eine zweite Ablenkfläche 26 aufweisen, die das Plasma ein weiteres mal umlenkt und streut, so dass es danach von den Benachbarten Leiterbahnen 60 wegfliesst.

Bevorzugt werden die Trennwand 8 und die Ablenkfläche(n) 16, 26 jedoch zusammen mit dem Gehäuse 22 ausgebildet. Dies hat den Vorteil geringerer Kosten, da kein zusätzliches Bauteil gefertigt und montiert werden muss. Bei der Montage von Leiterplatte 1 und Gehäuse 22 sitzt die Trennwand dann automatisch an der richtigen Stelle.

## Patentansprüche

1. Platine (1) mit darauf angebrachten elektrischen Leiterbahnen (2, 3, 4, 60) zur elektrischen Verbindung von auf der Leiterplatte montierten Bauteilen, die mindestens eine Leiterbahnsicherung (2, 3, 4) bestehend aus einem Zuführungsteil (2, 3, 5) und einem Schmelzsicherungsteil (4), wobei der Zuführungsteil (2, 3, 5) aus zwei Leiterbahnzuführungen (2, 3) und 2 Durchkontaktierungen (5) besteht, und der Schmelzsicherungsteil (4) eine Leiterbahn ist, wobei bei Auftreten eines anormalen Betriebszustands, insbesondere eines elektrischen Kurzschlusses, der Stromkreis durch Schmelzen und Verdampfen des Schmelzsicherungsteils (4) unterbrochen wird und beim Verdampfen des Schmelzsicherungsteils Plasma (21) entsteht, **dadurch gekennzeichnet, dass** die Platine (1) eine doppelseitige Platine ist, dass sich der Schmelzsicherungsteil (4) zwischen den zwei Durchkontaktierungen (5) befindet, und der Schmelzsicherungsteil (4) auf der anderen Seite der Platine (1) liegt als die Leiterbahnzuführung (2, 3).

2. Platine nach Anspruch 1, **dadurch gekennzeichnet, dass** sich auf der Schmelzsicherungsseite (B) und/oder der Zuführungsseite (A) der Durchkontaktierungen (5) je ein SMD-Klebepunkt (6) befindet.

3. Platine nach einem der vorhergehenden Ansprüche, **dadurch gekennzeichnet, dass** sich der Schmelzsicherungsteil (4) auf der Platinenunterseite befindet.

4. Platine nach einem der vorhergehenden Ansprüche, **dadurch gekennzeichnet, dass** sich zwischen dem Schmelzsicherungsteil (4) und den benachbarten Leiterbahnen (60) eine isolierende Trennwand (8) befindet.

5. Platine nach einem der vorhergehenden Ansprüche, **dadurch gekennzeichnet, dass** die isolierende Trennwand durch ein geeignetes Bauteil oder aus mehreren geeigneten und geeignet angeordneten Bauteilen besteht.

6. Platine nach Anspruch 4, **dadurch gekennzeichnet, dass** an der Seite der Trennwand (8), die der Schmelzsicherung (4) zugewandt ist, zumindest eine Ablenkfläche (16, 26) zum Ablenken und Reflektieren des Plasmas ausgebildet ist.

7. Platine nach Anspruch 6, **dadurch gekennzeichnet, dass** die Ablenkfläche (16, 26) gegenüber der Platinenoberfläche schräg angeordnet ist.

## Claims

1. Printed circuit board (1) comprising electrical conductor tracks (2, 3, 4, 60) fitted thereon and serving for electrically connecting components mounted on the printed circuit board, which has at least one conductor track fuse (2, 3, 4) consisting of a supply line part (2, 3, 5) and a fusible link part (4), wherein the supply line part (2, 3, 5) consists of two conductor track supply lines (2, 3) and two through contacts (5), and the fusible link part (4) is a conductor track, wherein, upon the occurrence of an abnormal operating state, in particular an electrical short circuit, the electric circuit is interrupted by melting and evaporation of the fusible link part (4) and plasma (21) arises upon the evaporation of the fusible link part, **characterized in that** the printed circuit board (1) is a double-sided printed circuit board, **in that** the fusible link part (4) is situated between the two through contacts (5), and the fusible link part (4) lies on the other side of the printed circuit board (1) with respect to the conductor track supply line (2, 3).

2. Printed circuit board according to Claim 2, **characterized in that** a respective SMD adhesive spot (6) is situated on the fusible link side (B) and/or the supply line side (A) of the through contacts (5).

3. Printed circuit board according to either of the preceding claims, **characterized in that** the fusible link part (4) is situated on the underside of the printed circuit board.

4. Printed circuit board according to any of the preceding claims, **characterized in that** an insulating partition (8) is situated between the fusible link part (4) and the adjacent conductor tracks (60).

5. Printed circuit board according to any of the preceding claims, **characterized in that** the insulating partition comprises one suitable component or a plurality of suitable and suitably arranged components.

6. Printed circuit board according to Claim 4, **characterized in that** at least one deflection surface (16, 26) for deflecting and reflecting the plasma is formed on the side of the partition (8) which faces the fusible link (4).

7. Printed circuit board according to Claim 6, **characterized in that** the deflection surface (16, 26) is arranged obliquely relative to the surface of the printed circuit board.

## Revendications

1. Platine (1) avec des pistes conductrices électriques (2, 3, 4, 60) placées sur la platine et destinées à la connexion électrique de composants montés sur la carte de circuit imprimé, l'au moins un fusible pour pistes conductrices (2, 3, 4) se composant d'une partie d'alimentation (2, 3, 5) et d'une partie coupe-circuit à fusible (4), dans laquelle la partie d'alimentation (2, 3, 5) se compose de deux alimentations pour pistes conductrices (2, 3) et de deux trous d'interconnexion (5), et la partie coupe-circuit à fusible (4) est une piste conductrice, dans laquelle lors de la survenue d'un état de fonctionnement anormal, en particulier d'un court-circuit électrique, le circuit électrique est coupé par le biais d'une fusion et d'une évaporation de la partie coupe-circuit à fusible (4) et lors de l'évaporation de la partie coupe-circuit à fusible du plasma (21) est généré, **caractérisée en ce que** la platine (1) est une platine double face, **en ce que** la partie coupe-circuit à fusible (4) se trouve entre les deux trous d'interconnexion (5) et la partie coupe-circuit à fusible (4) est située sur l'autre face de la platine (1) que l'alimentation pour piste conductrice (2, 3).

2. Platine selon la revendication 1, **caractérisée en ce que** sur la face coupe-circuit à fusible (B) et/ou la face alimentation (A) des trous d'interconnexion (5) se trouvent respectivement un point de collage pour CMS (6).

3. Platine selon l'une des revendications précédentes, **caractérisée en ce que** la partie coupe-circuit à fusible (4) se trouve sur la face inférieure de la platine.

4. Platine selon l'une des revendications précédentes, **caractérisée en ce que,** entre la partie coupe-circuit à fusible (4) et les pistes conductrices (60) adjacentes se trouve une paroi de séparation isolante (8).

5. Platine selon l'une des revendications précédentes, **caractérisée en ce que** la paroi de séparation isolante se compose d'un composant adéquat ou de plusieurs composants adéquats ou disposés de manière adéquate.

6. Platine selon la revendication 4, **caractérisée en ce que,** au niveau de la face de la paroi de séparation (8) qui est tournée vers le coupe-circuit à fusible (4), au moins une surface de déviation (16, 26) destinée à dévier et à refléter le plasma est réalisée.

7. Platine selon la revendication 6, **caractérisée en ce que** la surface de déviation (16, 26) est disposée inclinée par rapport à la surface de la platine.
